# EUROPÄISCHE PATENTSCHRIFT

(11) **EP 2 825 343 B1**
(45) Veröffentlichungstag und Bekanntmachung des Hinweises auf die Patenterteilung: **14.12.2016**
(21) Anmeldenummer: 13711330.4
(22) Anmeldetag: 15.03.2013
(51) Int. Cl.: B23K 1/00

(54) **MIKROSTRUKTURBAUTEIL UND VERFAHREN ZU DESSEN HERSTELLUNG**
MICROSTRUCTURE AND METHOD OF PRODUCING THE SAME
PIÈCE COMPORTANT UNE MICROSTRUCTURE ET PROCÉDÉ DE FABRICATION

(30) Priorität: 16.03.2012 DE 102012204178
(43) Veröffentlichungstag der Anmeldung: 21.01.2015
(73) Patentinhaber: Fraunhofer Gesellschaft zur Förderung der angewandten Forschung e.V., 80686 München (DE)
(72) Erfinder: HOFMANN, Christian, 55118 Mainz (DE); KRTSCHIL, Ulrich, 55131 Mainz (DE)
(74) Vertreter: Mehler Achler
(86) Internationale Anmeldenummer: PCT/EP2013/055377
(87) Internationale Veröffentlichungsnummer: WO 2013/135866

(56) Entgegenhaltungen:
- WO-A2-2006/131685
- DE-A1- 3 126 948
- DE-A1- 10 108 469
- DE-C1- 19 801 374
- US-A1- 2001 021 462

## Beschreibung

Die Erfindung betrifft ein Mikrostrukturbauteil in Stapelbauweise zum Leiten eines Fluids, insbesondere einen mikrofluidischen Stapelreaktor oder -wärmetauscher, und ein Verfahren zu dessen Herstellung.

Unter Mikrostrukturbauteil in Stapelbauweise werden Mikroreaktoren, Mikromischer und Mikrowärmetauscher verstanden, die aus einem Stapel strukturierter Platten oder Bleche zusammengesetzt sind. Im zusammengesetzten Zustand bilden sich bedingt durch die Mikrostruktur in den Platten sehr feine Kanäle oder allgemeiner Fluidleitungen aus, deren Querschnittsfläche zumindest Abschnittsweise in der Größenordnung eines Quadratmillimeters in einer Richtung quer zur Fließrichtung oder darunter beträgt.

Solche Mikrostrukturbauteile sind beispielsweise in der Schrift EP1 415 748 B1 beschrieben. Die dort genannten Anforderungen, interne und externe Dichtigkeit des Mikrostrukturbauteils, d.h zwischen den Fluidleitungen wie auch zur Umgebung, hohe Druckfestigkeit, Korrosionsbeständigkeit, Temperaturbeständigkeit und geometrisch exakt definierte Kanäle, sind zutreffend beschrieben. Die Schrift befasst sich davon ausgehend mit der Fügetechnik der aufeinander gestapelten Platten und bevorzugt zur Verbindung derselben ein Lötverfahren, bei dem auf die Fügeflächen der einzelnen Bauteillagen zuerst eine Barriereschicht und anschließend eine Lotschicht aufgebracht, vorzugsweise mittels Siebdruck aufgedruckt, die vorbereiteten Bauteillagen anschließend gestapelt und unter Wärmeeinwirkung miteinander verlötet werden. Durch die Verwendung einer Diffusionssperrschicht sollen unerwünschte Wechselwirkungen zwischen der Lotschicht und dem Plattenmaterial vermieden werden, die für eine nachlassende Dichtigkeit unter hohem Druck verantwortlich gemacht werden. Im Ergebnis befasst sich die Schrift also mit einer verbesserten Haltbarkeit der Verbindung zwischen den aufeinandergestapelten Platten. Eine Verfahren zur Herstellung der Mikrostruktur wird darin nicht thematisiert.

Die Schrift DE 198 01 374 C1 befasst sich ebenfalls mit den gattungsgemäßen Mikrostrukturbauteilen. Auch hierin wird u. a. das Vakuumlöten als bewehrtes Fügeverfahren genannt. Wie auch in der vorstehend genannten Schrift werden Stapel aus strukturierten Platten gebildet, zwischen denen Lotschichten entweder in Form einer separaten Folie, einer aufgetragenen Paste eines Pulvers oder einer galvanisch auf der Platte abgeschiedenen Schicht aufgebracht werden. Als Strukturierungsverfahren werden das Ätzen, Fräsen, Prägen, Stanzen oder Drahterodieren der einzelnen strukturierten Platten genannt.

Das Prägen einer wellenförmigen Struktur in ein Blech ist beispielsweise in der Schrift DE 101 08 469 B4 beschrieben. Dieses Prägeverfahren wie auch die vorgenannten Strukturierungsverfahren sind sehr kostenintensiv und deshalb als Standard für eine Massenproduktion nur bedingt geeignet.

Der vorliegenden Erfindung liegt die Aufgabe zugrunde, ein Mikrostrukturbauteil in Stapelbauweise und ein Verfahren zu dessen Herstellung bereitzustellen, welche eine industrielle Serienfertigung ermöglichen.

Die Aufgabe wird erfindungsgemäß durch ein Verfahren mit den Merkmalen des Patentanspruchs 1 und ein Mikrostrukturbauteil mit dem Merkmal des Patentanspruchs 9 gelöst. Vorteilhafte Weiterbildungen sind Gegenstand der Unteransprüche.

Das erfindungsgemäße Verfahren zur Herstellung eines Mikrostrukturbauteils in Stapelbauweise, insbesondere eines mikrofluidischen Stapelreaktors oder Wärmetauschers, sieht die folgenden Schritte vor:
- Führen eines Blechs durch einen eine Breitenrichtung definierenden Spalt eines Profil-Walzenpaares, wobei das Blech mikrostrukturiert wird und wobei ein Wellenprofil in Breitenrichtung, also quer zur Walzrichtung erzeugt wird,
- Ablängen einer mikrostrukturierten Platte aus dem mikrostrukturierten Blech,
- Aufbringen eines Lotes auf eine unstrukturierte Platte, vorzugsweise mittels Siebdruck,
- Zusammensetzen der mikrostrukturierten und der unstrukturierten Platten zu einem Stapel und
- Verbinden des Stapels mittels Vakuumlöten.

Durch das abwechselnde Stapeln der mikrostrukturierten Platten und der unstrukturierten Platten - als unstrukturiert werden Platten bezeichnet, die im wesentlichen bis auf herstellungsbedingte Unebenheiten ebene Oberflächen aufweisen - bilden sich auf beiden Seiten der mikrostrukturierten Platten zwischen deren Oberflächen und den angrenzenden Oberflächen der jeweils benachbarten unstrukturierten Platten Fluidleitungen oder Kanäle aus.

Ein signifikanter Unterschied des erfindungsgemäßen Verfahrens im Vergleich mit bekannten Herstellungsverfahren besteht in dem Schritt des Strukturierens. Das Erzeugen eines Wellenprofils, d. h. einer wechselseitigen Strukturierung des Bleches von der Ober- und Unterseite ist im Bereich der Herstellung mikrostrukturierter Bauteile für Fiuidikanwendungen nicht geläufig, weil es bisher nicht gelang, diese mit hinreichender Genauigkeit herzustellen.

Für makroskopische Wärmetauscher oder andere Anwendungen wie Abgasfilter oder Schalldämpfer für Verbrennungskraftmaschinen ist ein auf den ersten Blick ähnliches Verfahren beispielsweise aus der Schrift US 2001/0021462 A1 bekannt. Hiernach werden ein wellenförmig strukturiertes Blech und ein unstrukturiertes Blech gemeinsam zu einem zylindrischen Monolithen aufgewickelt, so dass sich strukturierte und unstrukturierte Blechbahnen in radialer Richtung abwechseln. Zur Sicherstellung eines möglichst genau definierten und großen Strömungsquerschnittes schlägt die Schrift vor, das strukturierte Blech in zwei aufeinanderfolgenden Umformungsschritten zu profilieren. Zunächst wird in einem ersten Walzschritt eine annähernd sinusförmige Wellenstruktur mit abgerundeten Wellenbergen und -tälern geformt, die anschließend in einem zweiten Walzschritt zu spitz ausgeformten, dreieckförmigen Rillen umgeformt werden. Das Umformungsverfahren ist ein Biegeverfahren, genauer ein Wellbiegen, bei dem das Blech eine Wellenstruktur in Walz- oder Längenrichtung erhält.

Dasselbe Umformungsverfahren kommt auch bei der Herstellung eines flächigen Verbundmaterials gemäß der Schrift DE 31 26 948 A1 zum Einsatz, bei dem eine erste Blechbahn zwischen zwei ineinander greifenden Profilwalzen profiliert und mit mindestens einer zweiten planen Blechbahn kontinuierlich zusammengeführt und verbunden wird. Alternativ schlägt die Schrift vor, eine Blechbahn zunächst auf beiden Seiten mit einem Lotüberzug zu versehen, danach zu profilieren und abzulängen. Die profilierten Blechbahnabschnitte werden jeweils zwischen zwei planen Blechbahnabschnitten gestapelt und unter Druck im Vakuum verlötet.

Die Praxis hat gezeigt, dass sich dieses Verfahren nicht mit hinreichender Genauigkeit auf die Erzeugung von Mikrostrukturbauteilen für mikrofluidische Anwendungen übertragen lässt. Die Probleme reichen von mangelnder Maßhaltigkeit des Wellenprofils bis zu mangelnder Planheit der strukturierten Bleche und Platten. Beides sorgt dafür, dass die erforderliche Genauigkeit bei den anschließenden Fügeschritten nicht sichergestellt ist.

Auch diese Erfindung sieht vor, das Blech in einem Walzprozess, also kontinuierlich herzustellen. Sie grenzt sich von dem vorstehend diskutierten bekannten Strukturierungs- oder Profilierungsverfahren aber dadurch ab, dass das Wellenprofil in Breitenrichtung, also quer zur Walzrichtung erzeugt wird. Dies ist ähnlich dem Walzprofilieren, jedoch handelt es sich nicht um ein reines Biegeumformen sondern überwiegend um ein Hohlprägen, also um einen Zugumformprozess, bei dem das Blechmaterial fließt. Auch dieses Verfahren ist grundsätzlich bekannt. Es wird auf die Schrift AT 187078 B verwiesen. Diese offenbart ein Verfahren zur Herstellung von Wellblech, bei dem ein ebenes Blech in seiner ganzen Breite zwischen kannelierte Walzen eingeführt wird, die in einem einzigen Arbeitsgang die Bildung von Wellen im Blech durch Ziehen des Metalls bewerkstelligen. Der Materialquerschnitt des Bleches verringert sich bei dieser Art der Umformung. Dieser Umstand stellt nicht nur eine hohe Maßgenauigkeit der Mikrostruktur sondern überraschenderweise auch eine ausgezeichnete Planheit des Bleches sicher. Zur Planheit trägt ferner bei, wenn das Blech vorteilhafter Weise über seine vollständige Breite in einem Durchlauf profiliert wird. Die Planheit kann im Bedarfsfall durch einen anschließenden Richtschritt noch verbessert werden. In jedem Fall ist die ausgezeichnete Planheit bereits nach dem Strukturieren aber eine wichtige Verbesserung, weil weniger plane Profilbleche, wie sie die bekannten Wellbiegeverfahren produzieren, hohe Umformgrade beim Richten bedingen, die aber wiederum die Strukturgenauigkeit des Wellenprofils beeinträchtigen. Durch die verbesserte Planheit und Maßhaltigkeit kann unter Einsatz von sehr wenig Lot eine stabile Verbindung zwischen den gestapelten Platten, eine sichere Einhaltung der Fluidleitungsquerschnitte und damit eine insgesamt hohe Prozesssicherheit erreicht werden.

Ein weiterer Vorteil des erfindungsgemäß eingesetzten Strukturierungsverfahrens ist, dass das Wellenprofil über eine quasi endlose Länge erzeugt werden kann, sodass aus mikrostrukturiertem Blech oder Band Platten beliebiger Länge abgelängt werden können, ohne dass dabei nennenswerter Verschnitt anfällt. Das Ablängen kann nach Bedarf mit einer geraden Schnittkante rechtwinklig zur Längenrichtung oder schrägwinklig oder auch mit einer nicht geraden Schnittkante erfolgen. Insbesondere können zwei oder mehr Platten unterschiedlicher Länge aus demselben Blech in einem einfachen Schneidvorgang hergestellt werden. Sämtliche Platten können aus diesen Gründen mit einem einzigen Walzschritt hergestellt werden.

Das Aufbringen des Lotes auf die unstrukturierte Platte erfolgt beispielsweise mittels Aufbringen strukturierter Lotfolien mittels Beschichtung oder Aufdrucken, vorzugsweise mittels Siebdruck.

Bevorzugt wird das Wellenprofil periodisch strukturiert.

Das Blech wird beim Strukturieren vorzugsweise mit einer Hilfsstruktur versehen, die eingerichtet ist das Blech beim Strukturieren in Breitenrichtung zu fixieren.

Das Blech kann beim Umformprozess zwischen den Walzen des Profil-Walzenpaares durch das Einbringen zusätzlicher Hilfsstrukturen im Vergleich mit einem beispielsweise gleichförmigen Sinusprofil sicherer gehalten werden, so dass keine oder zumindest keine wesentliche Breitenreduzierung des Bleches beim Umformen zu verzeichnen ist. Dies stellt sicher, dass die Umformung überwiegend durch Zugumformung erfolgt, was die Präzision der Umformung und damit nochmals die Maßhaltigkeit und Planheit der strukturierten Bleche und Platten verbessert. Die Hilfsstrukturen weisen bevorzugt kleinere Biegeradien auf, als diese für die mikrofluidisch funktionalen Strukturen notwendig sind. Die kleineren Radien bewirken eine größere Reibung und vermindern dadurch eine seitliche Bewegung des Bleches.

Besonders bevorzugt erhält das Blech beim Strukturieren in Längen- oder Walzrichtung verlaufende Wellenberge und Wellentäler, die jeweils im Scheitelbereich mit rillenförmigen Einbuchtungen versehen werden.

Als rillenförmige Einbuchtungen werden sich in Längenrichtung erstreckende Einbuchtungen verstanden, die das Wellenprofil in den Scheitellbereichen der Wellenberge und Wellentäler der Gestalt überlagern, dass die Wellenberge einwärts, also zur Mittellinie hin gerichtete lokale Minima bzw. die Wellentäler einwärts, also zur Mittellinie hin gerichtete lokale Maxima aufweisen.

Die rillenförmigen Einbuchtungen bilden bevorzugt zusammen mit der angrenzenden Oberfläche der benachbarten unstrukturierten Platte einen Hohlraum, in dem sich das Lot beim Vakuumlöten sammelt.

Die Struktur ist durch das erfindungsgemäße Strukturierungsverfahren so an die Anforderungen des Fügeverfahrens angepasst. Die Profilform der rillenförmigen Einbuchtungen kann dabei mit ausreichender Genauigkeit vorzugsweise so ausgestaltet werden, dass diese, verglichen mit dem überlagerten Wellenprofil (auch Grundstruktur) flach sind, d. h. insbesondere eine betragsmäßig geringere maximale Steigung aufweisen als diese. Dies stellt sicher, dass sich das flüssige Lot aufgrund der dort höheren Kapilarkraft in den Spalten zwischen den Einbuchtungen und der angrenzenden Oberfläche der benachbarten unstrukturierten Platte sammelt und nicht so sehr in den Spalten zwischen dem überlagerten Wellenprofil und der angrenzenden Oberfläche der benachbarten unstrukturierten Platte.

Zudem hat sich überraschend herausgestellt, dass die Einbuchtungen zugleich Hilfsstrukturen in vorstehendem Sinne bilden, die das Blech beim Umformprozess oder Strukturieren in Breitenrichtung fixieren. Im Vergleich mit einem Blech der gleichen Grundstruktur aber ohne die rillenförmigen Einbuchtungen erfährt das Blech mit Einbuchtungen beim Umformen eine signifikant geringere Breitenreduktion und damit eine deutlich höhere Maßhaltigkeit der Mikrostruktur und Planheit. Dieser Effekt wird darauf zurück geführt, dass die Einbuchtungen jeden Wellenberg und jedes Wellental der Grundstruktur teilen, so dass jeweils zwei Wellenberge und Täler mit kleineren Radien als die der Grundstruktur entstehen. Die kleineren Biegeradien bewirken eine größere Reibung beim Umformen. Zudem sind die Einbuchtungen als Haltestrukturen auch deshalb wirkungsvoll, weil sie sich über die gesamte Breite des Bleches mit der Periodizität der Grundstruktur wiederholen.

Die Einbuchtungen erfüllen mithin eine Doppelfunktion als Hilfsstruktur beim Umformen und als Hohlraum zur Aufnahme des Lotes beim Verbinden der Platten.

Um das Ergebnis des Vakuumlötens hinsichtlich möglichst lotfreier Fluidleitungen zu verbessern, wird das Lot bevorzugt lokal in Form von parallelen Streifen auf die unstrukturierte Platte aufgebracht bzw. aufgedruckt, wobei der Abstand der parallelen Streifen dem Abstand der Wellenberge bzw. dem Abstand der Wellentäler oder - im Fall einer periodischen Wellenstruktur - deren Periodizität entspricht.

Die Wellenberge und/oder Wellentäler der strukturierten Platte, je nachdem, ob die mikrostrukturierte Platte auf der Oberseite oder der Unterseite mit der unstrukturierten Platte zusammengefügt werden soll, werden dann beim Zusammensetzen mit den Lotstreifen der unstrukturierten Platte zur Deckung gebracht. Wird ein Stapel aus mehreren abwechselnd aufeinandergestapelten mikrostrukturierten Platten und unstrukturierten Platten gebildet und ist das Wellenprofil der mikrostrukturierten Platten symmetrisch, so sind die Lotstreifen auf der angrenzenden Oberfläche der benachbarten unstrukturierten Platte der einen Seite um eine halbe Wellenlänge gegenüber den Lotstreifen auf der angrenzenden Oberfläche der benachbarten unstrukturierten Platte der anderen Seite versetzt aufzubringen.

Durch das lokale Aufbringen oder Aufdrucken des Lotes in an die Wellenstruktur angepassten Streifen ist das Lot von Anfang nur vorhanden, wo es für die Fixierung und Abdichtung der Platten benötigt wird. Bevorzugt ist es ferner auf die für eine druckstabile Fixierung und Abdichtung benötigte Menge reduziert, indem das Volumen des Lotes beim Aufdrucken des Lotstreifens so eingestellt wird, dass es im Wesentlichen dem Volumen des Hohlraumes zwischen den rillenförmigen Einbuchtungen und der angrenzenden Oberfläche der benachbarten unstrukturierten Platte entspricht.

Hierdurch wird sichergestellt, dass in Verbindung mit dem vorstehend geschilderten Kapillareffekt kein wesentlicher Anteil des Lotes in den Bereich der Fluidkanäle gelangt, deren Querschnittsfläche sich deshalb nicht unbeabsichtigt oder undefiniert verengt. Kleine Lotanteile sind zwar auch hier an den schmalsten Stellen der Spalte zwischen der strukturierten und der unstrukturierten Platte zu finden. Dies ist der Stabilität der Struktur auch zuträglich und sorgt dafür, dass keine Toträume bildenden Spalte in den Fluidleitungen verbleiben. Diese Räume sind jedoch vergleichsweise klein und können aufgrund der exakten Geometrie des Wellenprofils genau eingestellt werden.

Die Aufgabe wird ferner durch ein Mikrostrukturbauteil in Stapelbauweise zum Leiten eines Fluids, insbesondere einen mikrofluidischen Reaktor, Wärmetauscher oder Mischer, mit abwechselnd aufeinander gestapelten mikrostrukturierten Platten und unstrukturierten Platten gelöst, wobei die mikrostrukturierten Platten ein Wellenprofil mit in Breitenrichtung aufeinanderfolgenden Wellenbergen und Wellentälern aufweisen, die jeweils im Scheitelbereich rillenförmige Einbuchtungen aufweisen, wobei in den Scheitelbereichen Lotverbindungen zwischen den mikrostrukturierten und unstrukturierten Platten bestehen und das Lot einen zwischen den rillenförmigen Einbuchtungen und einer angrenzenden Oberfläche der benachbarten unstrukturierten Platte gebildeten Hohlraum ausfüllt und wobei zwischen den Platten Fluidleitungen ausgebildet sind, die jeweils von einer Oberfläche der mikrostrukturierten Platte und einer angrenzenden Oberfläche der benachbarten unstrukturierten Platte in Umfangsrichtung begrenzt sind.

Dies unterscheidet die vorliegende Erfindung wesentlich von bekannten Mikrostrukturbauteilen in Stapelform, bei denen einseitig strukturierte Platten mit gleicher Orientierung, d. h. mit planer Unterseite auf die strukturierte Oberseite der folgenden Platte gestapelt werden, und ermöglicht eine kostengünstige und damit für die serientaugliche Herstellung.

Wiederum ist bevorzugt von einem periodischen Wellenprofil auszugehen.

Besonders bevorzugt ist in dem Mikrostrukturbauteil eine erste mikrostrukturierte Platte mit einem Wellenprofil und einer Ausdehnung L1 in Längenrichtung und eine zweite mikrostrukturierte Platte mit dem Wellenprofil und einer Ausdehnung L2 in Längenrichtung vorgesehen, wobei die Ausdehnung L1 der ersten mikrostrukturierten Platte größer ist als die Ausdehnung L2 der zweiten mikrostrukturierten Platte und wobei das Mikrostrukturbauteil aufeinander folgend eine unstrukturierte Platte, eine zweite mikrostrukturierte Platte, eine unstrukturierte Platte und eine erste mikrostrukturierte Platte aufweist.

Der dadurch entstehende Längenversatz der beiden strukturierten Platten dient dazu, in einfacher Weise getrennte Anschlussmöglichkeiten für abwechselnd aufeinanderliegende Fluidebenen in dem Stapel zur Verfügung zu stellen.

Bevorzugt ist die erste mikrostrukturierte Platte in der Plattenebene beidseitig in Längenrichtung von Leisten eingefasst.

Entsprechend ist die zweite mikrostrukturierte Platte in der Plattenebene umlaufend von einem Rahmen eingefasst, der auf den beiden Stirnseiten der mikrostrukturierten Platte jeweils eine Verteilerstruktur zum Verteilen von Fluid in Breitenrichtung auf die Fluidleitungen zwischen der zweiten mikrostrukturierten Platte und den beiden benachbarten unstrukturierten Platten bildet.

Weitere Merkmale und Vorteile der Erfindung werden nachfolgend anhand von Ausführungsbeispielen erläutert. In den Figuren zeigen:
- Figur 1: eine schematische Darstellung eines Profilwalzenpaares zur Erläuterung des Schrittes der Mikrostrukturierung eines Bleches;
- Figur 2: einen zusammengesetzten Stapel aus unstrukturierten, ersten und zweiten mikrostrukturierten Platten;
- Figur 3: den Stapel gemäß Figur 2 nach dem Vakuumlöten;
- Figur 4: eine Explosionsdarstellung eines Stapels unstrukturierter und mikrostrukturierter Platten, Leisten und Rahmen und
- Figur 5: eine perspektivische Darstellung einer Anschlussvariante an ein Mikrostrukturbauteil.

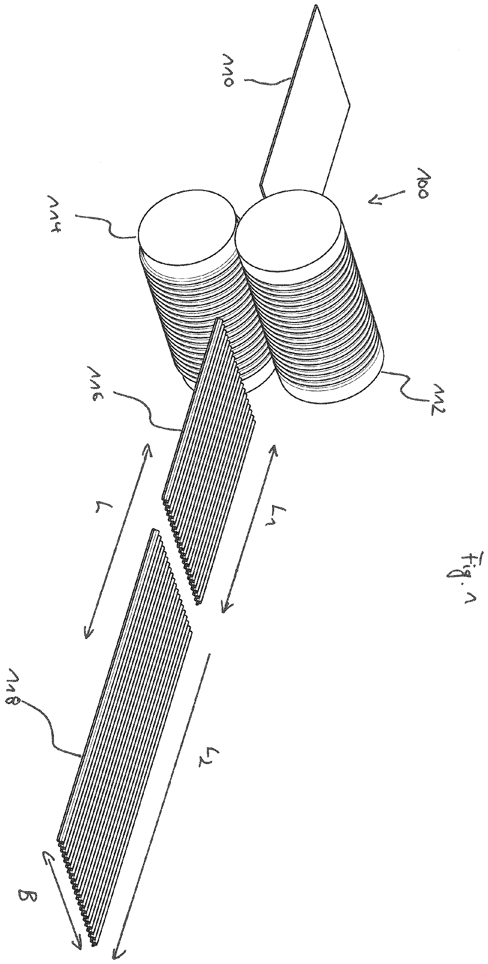

In Figur 1 ist ein Profil-Walzenpaar 100 zum Ausführen des Mikrostrukturierungsschrittes nach dem erfindungsgemäßen Verfahren gezeigt. Ein streifenförmiges Blech oder Band 110 wird von einem nicht dargestellten Vorrat zugeführt, beispielsweise von einem Coil abgewickelt, und durch einen Spalt des Profil-Walzenpaares 100 hindurchgeführt. Die Transport- oder Walzrichtung definiert die Längenrichtung L des Bleches. Dabei wird das Blech mit einer Mikrostruktur, genauer einem Weilenprofil, welches sich in der quer zur Längenrichtung verlaufenden Breitenrichtung oder Breite B abzeichnet, im Wesentlichen in einer Hohlprägetechnik versehen. Zu diesem Zweck weisen die beiden Prägewalzen 112, 114 jeweils umlaufende Vertiefungen und Erhöhungen auf, die im Querschnitt das Wellenprofil ergeben. Die eine der beiden Proflwalzen bildet gewissermaßen einen Stempel und die andere ein Gegenwerkzeug, welches eine Negativform des Profils des Stempels aufweist. Dadurch wird auf der Vorder- und der Rückseite des Bleches gleichzeitig ein Wellenprofil erzeugt, was das vorliegende Umformverfahren von einem Prägeverfahren unterscheidet.

Figur 1 zeigt weiterhin, dass sich die Umformung von einem bis zum anderen Rand des mikrostrukturierten Bleches erstreckt, weil die prägenden Strukturen auf den beiden ProfilWalzen 112, 114 wenigstens die Breite des zugeführten Blechstreifens oder eine größere Breite als dieser aufweisen. Das so mikrostrukturierte Blech kann folglich bereits mit dem Umformen sein Endmaß in Breitenrichtung B erhalten und muss nicht entlang seiner Längskanten, gemeint sind hiermit die in Längenrichtung L verlaufenden Kanten, nachträglich beschnitten werden. Zwar ist auch hier eine geringfügige Reduktion der Breite durch den Umformschritt zu berücksichtigen. Jedoch kann diese bei der Wahl der Breite des Ausgangsmaterials berücksichtigt werden. Außerdem lässt sich hierdurch eine sehr gute Planarität des erzeugten Bleches erzielen, während sich gezeigt hat, dass ein Blechstreifen mit auslaufendem Wellenprofil zu einer Durchbiegung in Breitenrichtung neigt.

Andeutungsweise ist auch der Schritt des Ablängens von mikrostrukturierten Platten 116, 118 im Anschluss an das Mikrostrukturieren des Bleches gezeigt. Das Ablängen kann in bekannter Weise durch Sägen oder vorzugsweise durch Laserstrahlschneiden erfolgen, was die Mikrostruktur entlang der Schnittkante weniger schädigt. Aus dem mikrostrukturierten Blech 110 können auf diese Weise mikrostrukturierte Platten unterschiedlicher Länge hergestellt werden. So ist angedeutet, dass die erste mikrostrukturierte Platte 116 eine größere Ausdehnung L₁ in Längenrichtung L aufweist als die zweite mikrostrukturierte Platte 118, vergleiche L₂.

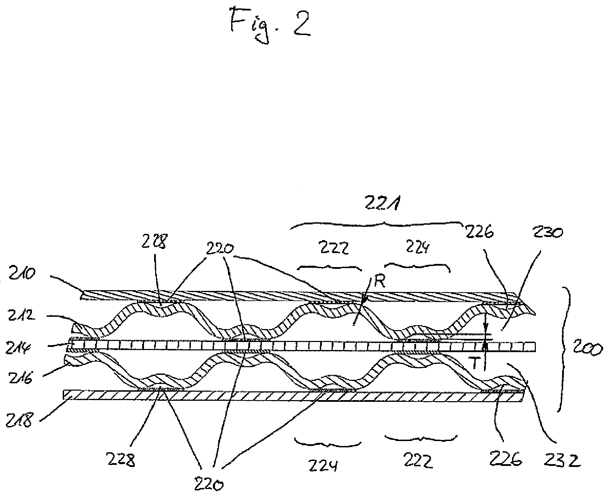

Figur 2 zeigt einen Stapel 200, der aus einer ersten unstrukturierten Platte 210, einer ersten mikrostrukturierten Platte 212, einer zweiten unstrukturierten Platte 214, einer zweiten mikrostrukturierten Platte 216 und einer dritten unstrukturierten Platte 218 zusammengesetzt ist. Auf den ersten, zweiten und dritten unstrukturierten Platten sind jeweils mehrere Lotstreifen 220 aufgedruckt. Figur 2 zeigt die Platten in einem Querschnitt in Breitenrichtung, in dem die Lotstreifen 220 als lokal unzusammenhängende Schnittflächen dargestellt sind.

Die mikrostrukturierten ersten und zweiten Platten 212, 216 weisen in dieser Darstellung jeweils ein periodisches Wellenprofil 221 mit in Walzrichtung, also senkrecht zur Darstellungsebene, verlaufenden Wellenbergen 222 und Wellentälern 224 auf. Es ist dazu zu sagen, dass Wellenberge und -täler sich aufgrund der Symmetrie des Wellenprofils nur durch ihre Orientierung unterscheiden, die Differenzierung nach Wellenberge und -tälern also von der Betrachtungsrichtung abhängt. Dreht man die mikrostrukturierten Platten 212, 216 um, werden der Wellenberg zum Wellental und das Wellental zum Wellenberg.

Ferner ist in Figur 2 zu erkennen, dass die Wellenberge und -täler jeweils in ihrem Scheitelbereich mit zur Mittelebene des Wellenprofils zeigenden rillenförmigen Einbuchtungen 226 mit einer Tiefe T versehen sind. Jeder Wellenberg und jedes Wellental des eigentlichen Wellenprofils erhalten so jeweils zwei gleich hohe Scheitelpunkte mit jeweils kleineren Radien R als der gedachte Radius des überlagerten Grundprofils. Zwischen den rillenförmigen Einbuchtungen 226 und den angrenzenden Oberflächen der jeweils benachbarten unstrukturierten Platten 210, 214, 218 bilden sich beim Zusammensetzen Hohlräume 228 aus. Wie zu sehen ist, sind die Flanken der rillenförmigen Einbuchtungen flacher ausgestaltetet als die der überlagerten Wellenstruktur. Jeder Wellenberg 222 und jedes Wellental 224 kommen mit zugeordneten Lotstreifen auf der jeweils angrenzenden Oberfläche der benachbarten unstrukturierten Platten 210, 214, 218 zur Deckung. Figur 2 zeigt den zusammengesetzten Stapel vor dem Löten.

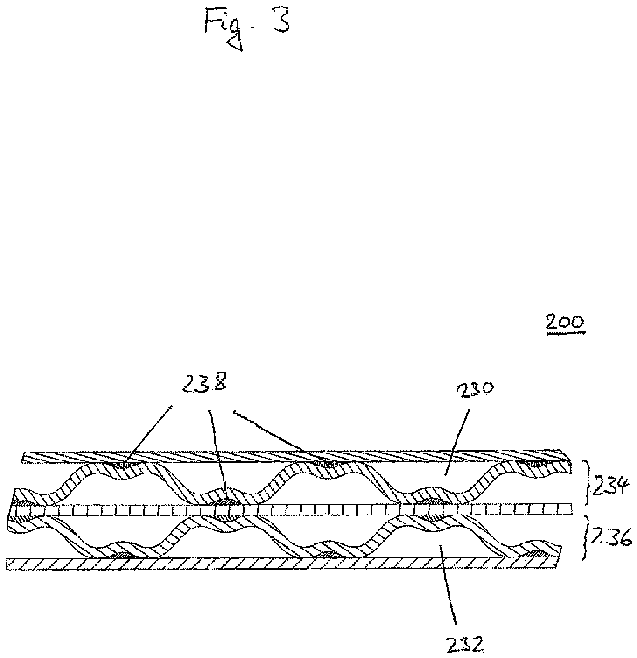

Die zwischen den mikrostrukturierten Platten 212, 216 und den jeweils benachbarten unstrukturierten Platten 210, 214, 218 unterhalb der Wellenberge 222 bzw. oberhalb der Wellentäler 224 eingeschlossenen Hohlräume 230, 232 bilden Fluidleitungen, die sich senkrecht zur Darstellungsebene erstrecken. Alle zwischen jeweils zwei benachbarten unstrukturierten Platten angeordneten parallelen Fluidleitungen 230, 232 bilden eine Fluidebenen 234, 236, wie Figur 3 zu entnehmen ist.

Die bevorzugten Dimensionen der mikrostrukturierten Platten betragen: Dicke des Plattenmaterials ca. 0,1 bis 0,25 mm, Radien R der Scheitelpunkte < 0,5 mm, Wellenlänge des Grundprofils 2 bis 4 mm und Tiefe T der Einbuchtungen 0,3 bis 0,6 mm.

In Figur 3 ist derselbe Stapel 200 nach dem Löten dargestellt. Es ist zu sehen, dass sich das Lot beim Vakuumlöten, das unter senkrechtem Druck auf den Stapel durchgeführt wird, in den Hohlräumen 228 sammelt und diese ausfüllt. Kein nennenswerter Anteil des Lotes verbleibt im Querschnitt der Fluidleitungen 230, 232. Diese Verteilung des Lotes beim Löten ist zum einen durch die exakte Übereinstimmung der Position der Lotstreifen 220 mit der der Wellenbergen 222 bzw. Wellentälern 224 begründet. Zum anderen tragen die flachen Flanken der rillenförmigen Einbuchtungen 226 i. V. m. der Oberflächenspannung des flüssigen Lotes hierzu bei. Die Flanken des Wellenprofils 221 sind vergleichsweise steiler, sodass die Kapillarität hier nur zu einer weniger raumgreifenden Benetzung im Bereich der Berührungslinien zwischen den strukturierten Platten 212, 216 und den unstrukturierten Platten 210, 214, 218 führt.

Die in Figur 2 bzw. Figur 3 gezeigten Stapel stellen nur Ausschnitte des erfindungsgemäßen Mikrostrukturbauteils dar. Auf der Ober- und/oder Unterseite können sich weitere mikrostrukturierte und unstrukturierte Platten in jeweils abwechselnder Reihenfolge anschließen, wobei die jeweils aufeinanderfolgenden mikrostrukturierten Platten bevorzugt um eine halbe Wellenlänge seitlich versetzt anzuordnen sind. Das erfindungsgemäße Mikrostrukturbauteil weist typischerweise 10 bis mehrere hundert oder auch tausend Doppelschichten der gezeigten Art auf.

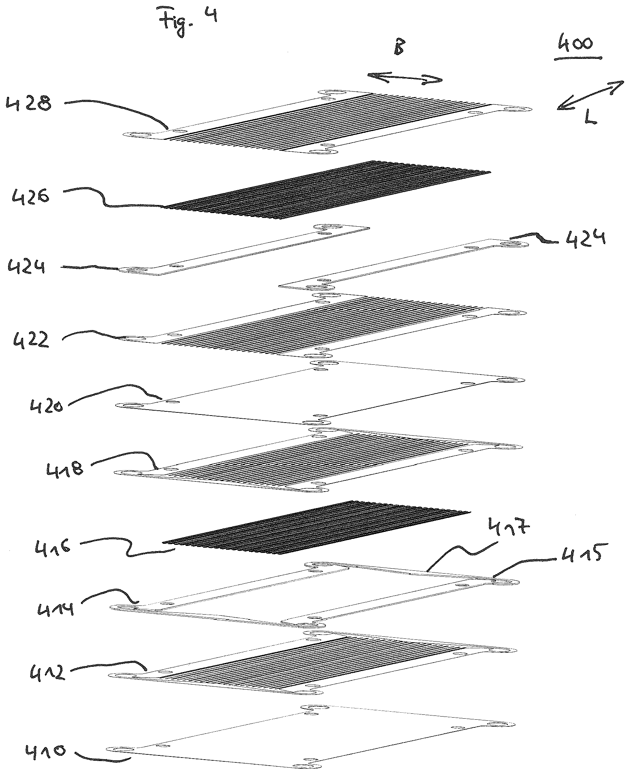

Figur 4 zeigt einen Stapel 400 von mikrostrukturierten und unstrukturierten Platten in Explosionsdarstellung und in perspektivischer Ansicht. Zuunterst ist eine unstrukturierte Platte 410 dargestellt, über der eine Lotschicht 412 schwebend dargestellt ist. Diese Darstellung dient der Illustration, die den Eindruck einer separaten Lotfolie vermittelt. Die Lotschicht 412 kann insbesondere aber auch durch Aufdrucken auf die unstrukturierte Platte 410 fest mit dieser verbunden sein und ist deshalb als schematisch zu betrachten.

Darüber ist ein Rahmen 414 gezeigt, der mittels des Lotes der Lotschicht 412 mit der darunterliegenden unstrukturierten Platte 410 fluiddicht verbunden ist. Der Rahmen 414 ist umlaufend geschlossen. Er besteht im Wesentlichen aus zwei in Längenrichtung verlaufenden breiteren Leistenelementen 415 sowie zwei einstückig daran angeformten stirnseitigen schmaleren Leistenelementen 417. Zwischen den Leistenelementen 415, 417 bildet sich ein im Wesentlichen rechteckiges Fenster aus, in welches eine zweite mikrostrukturierte Platte 416 eingelegt wird. Diese ist von dem Rahmen 414 umlaufend eingefasst. Die zweite mikrostrukturierte Platte 416 ist in Längsrichtung vorzugsweise kürzer, als das Fenster, sodass stirnseitig an der mikrostrukturierte Platte in Breitenrichtung offene Verteilerstrukturen ausgebildet werden. Ein zugeführtes Fluid wird darin in Breitenrichtung auf die Fluidleitungen verteilt. Über der Ebene des Rahmens 414 und der mikrostrukturierten Platte 416 befindet sich eine weitere unstrukturierte Platte 420 mit einem auf deren Unterseite aufgedruckten Lot 418, welches ein mit den Wellenbergen der zweiten mikrostrukturierten Platte 416 und den Leistenelementen 415, 417 des Rahmens 414 deckungsgleiches Muster bildet. Nach dem Fügen wird die zweite mikrostrukturierte Platte 416 durch das Lot allseitig fluiddicht und druckfest zwischen der unstrukturierten Platte 420, dem Rahmen 414 und der unstrukturierten Platte 410 eingeschlossen.

Auf der Oberseite der unstrukturierten Platte 420 befindet sich eine weitere aufgedruckte Lotschicht 422, deren Muster deckungsgleich mit den Berührungslinien der darauf angeordneten Bauteile ist. Diese Bauteile umfassen Leisten 424 und eine zwischen den Leisten 424 angeordnete erste mikrostrukturierte Platte 426. Die Leisten 424 sind beidseitig in Längenrichtung L parallel in der Ebene der ersten mikrostrukturierten Platte 426 neben dieser platziert und fassen diese ein. Die erste mikrostrukturierte Platte 426 weist in Längenrichtung L eine größere Ausdehnung auf, als die zweite mikrostrukturierte Platte 416, sodass die in der durch die erste mikrostrukturierte Platte 426 definierten Fluidebene liegenden Fluidleitungen stirnseitig offen sind.

Der Vollständigkeit halber ist oberhalb der ersten mikrostrukturierten Platte 426 nochmals eine Lotschicht 428 dargestellt, welche auf die Unterseite einer hier nicht dargestellten weiteren unstrukturierten Platte aufgedruckt sein soll. Die nicht dargestellte weitere unstrukturierte Platte ist identisch mit der zuunterst dargestellten unstrukturierten Platte 410. Der in Figur 4 gezeigte Stapel ergibt redundant aufeinandergesetzt und zusammen mit einer auf der Ober- und Unterseite angeordneten Abschlussplatte 510 einen Mikrostrukturbauteil 500, wie zum Beispiel einen mikrofluidischen Reaktor, Wärmetauscher oder Mischer.

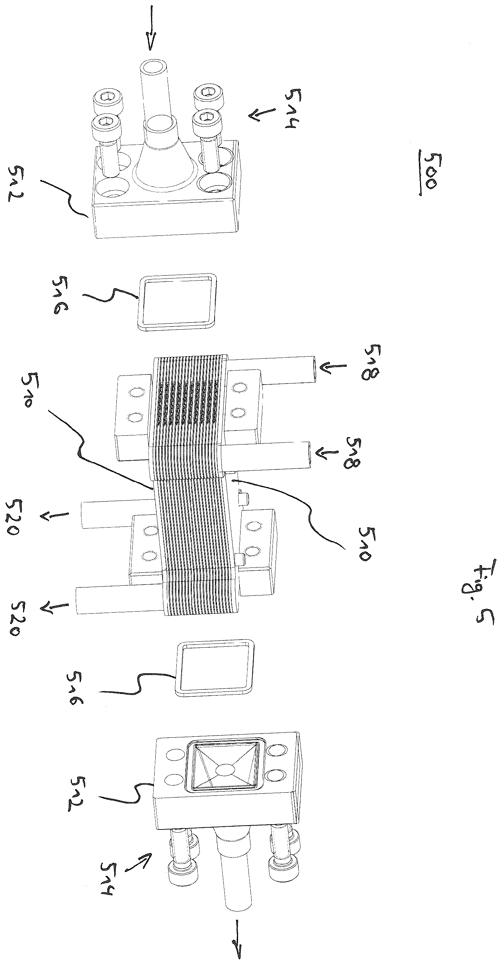

Dies ist in Figur 5 dargestellt. Die durch die erste mikrostrukturierte Platte 426 gekennzeichnete Fluidebene ist, wie bereits erwähnt, stirnseitig offen, sodass der so gebildete Mikrostrukturbauteil 500 stirnseitig mit dem Fluid angeströmt werden kann. Hierzu sind Anschlussflansche 512 vorgesehen, die mit Schraubverbindungen 514 an dem Mikrostrukturbauteil 500 beidseits befestigt werden und mittels Dichtungen 516 abgedichtet sind. Anstelle der Anschlussflansche 512 können stirnseitig unmittelbar auch weitere Mikrostrukturbauteile 500 der gleichen oder einer anderen Art angeflanscht sein.

Die durch die zweiten mikrostrukturierten Platten 416 definierten Fluidebenen werden typischerweise über eine oder mehrere vertikale Zuführungen 518, die einen seitlichen Eintritt des Fluids in die Verteilerstrukturen der Fluidebenen ermöglichen, angeströmt. In entsprechender Weise werden diese auf der gegenüberliegenden Seite über Verteilerstrukturen und Abführungen 520 entleert. Diese Fluidebene wird beispielsweise typischerweise als Kühlmittelleitung in einem Wärmetauscher verwendet und bildet in der Regel einen geschlossenen Kreislauf, während die durch ersten mikrostrukturierten Platte 426 definierten Fluidebenen von dem zu kühlenden Medium oder dem Reaktionsmedium durchströmt werden.

Zur Erfindung gehörend sind neben dem beispielhaft gezeigten Mikrostrukturbauteil 500 auch Mikrostrukturbauteile mit Stapeln aus Platten anderer Form, insbesondere Stapel aus mehr als zwei verschiedenen mikrostrukturierten Platten oder mehreren verschiedenen unstrukturierten Platten, Rahmenelementen oder Leistenelementen. Die Platten können grundsätzlich regelmäßige oder unregelmäßig wiederholt oder auch einzeln in dem Stapel auftreten. Abweichend von der rechtwinkligen Kontur der mikrostrukturierten Platten 116, 118, 212, 216, 416, 426 oder der unstrukturierten Platten 210, 214, 218, 410, 420 in den vorstehend diskutierten Ausführungsbeispielen, können diese auch eine andere Kontur aufweisen. Vorzugsweise sind die Längskanten fertigungsbedingt parallel, die Platten können abweichend jedoch schräg zur Längenrichtung L abgelängt sein. Insbesondere kann mit nicht-rechtwinkligen Stirnseiten an den strukturierten Platten ein Aufbau realisiert werden, bei dem ein Fluid statt stirnseitig über seitlich an dem Mikrostrukturbauteil angeschlossenen oder angeflanschte Zu- und Abführungen geleitet wird. Sind die abwechselnden Fluidebenen aus mikrostrukturierten Platten mit wechselseitig schrägen Stirnseiten gebildet können beide Fluide von unterschiedlichen Seiten über seitlich an dem Mikrostrukturbauteil angeschlossenen oder angeflanschte Zu- und Abführungen geleitet werden. Auch sind sogenannte Kreuzstromausführungen des Mikrostrukturbauteils zur Erfindung gehörend zu betrachten, bei denen sich die Fluidleitungen aufeinanderfolgender Fluidebenen kreuzen, beispielsweise unter rechtem Winkel.

### Bezugszeichenliste

- 100: Profil-Walzenpaar
- 110: Blechstreifen
- 112: Profilwalze
- 114: Profilwalze
- 116: erste mikrostrukturierte Platte
- 118: zweite mikrostrukturierte Platte

- 200: Stapel
- 210: unstrukturierte Platte
- 212: mikrostrukturierte Platte
- 214: unstrukturierte Platte
- 216: mikrostrukturierte Platte
- 218: unstrukturierte Platte
- 220: Lotstreifen
- 221: Wellenprofil
- 222: Wellenberg
- 224: Wellental
- 226: rillenförmige Einbuchtung
- 228: Hohlraum
- 230: Fluidleitung
- 232: Fluidleitung
- 234: Fluidebene
- 236: Fluidebene
- 238: Lotverbindungen

- 400: Stapel
- 410: unstrukturierte Platte
- 412: Lot/Lotebene
- 414: Rahmen
- 415: Leistenelement
- 416: zweite mikrostrukturierte Platte
- 417: Leistenelement
- 418: Lot/Lotebene
- 420: unstrukturierte Platte
- 422: Lot/Lotebene
- 424: Leiste
- 426: erste mikrostrukturierte Platte
- 428: Lot/Lotebene

- 500: Mikrostrukturbauteil
- 512: Anschlussflansch
- 514: Schraubverbindung
- 516: Dichtung
- 518: Zuführung
- 520: Abführung

- B: Breite/Breitenrichtung
- L: Länge/Längenrichtung
- L₁: Länge der ersten mikrostrukturierten Platte
- L₂: Länge der zweiten mikrostrukturierten Platte
- R: Radius des Scheitelpunktes
- T: Tiefe der Einbuchtung

## Patentansprüche

1. Verfahren zur Herstellung eines Mikrostrukturbauteils (500), bei dem
- ein Blech (110) durch einen eine Breitenrichtung (B) definierenden Spalt eines Profil-Walzenpaares (100) geführt und dabei mikrostrukturiert wird, wobei ein Wellenprofil (221) in Breitenrichtung (B) erzeugt wird,
- aus dem mikrostrukturierten Blech (110) eine mikrostrukturierte Platte (116, 118, 212, 216, 416, 426) abgelängt wird,
- auf eine unstrukturierte Platte (210, 214, 218, 410, 420) ein Lot (220, 412, 418, 422, 428) aufgebracht wird,
- die mikrostrukturierte Platte (116, 118, 212, 216, 416, 426) und die unstrukturierte Platte (210, 214, 218, 410, 420) zu einem Stapel (200, 400) zusammengesetzt werden
- und der Stapel (200, 400) mittels Vakuumlöten verbunden wird.

2. Verfahren nach Anspruch 1,
**dadurch gekennzeichnet, dass** das Wellenprofil (221) periodisch strukturiert wird.

3. Verfahren nach einem der vorstehenden Ansprüche,
**dadurch gekennzeichnet, dass** das Blech (110) beim Strukturieren mit einer Hilfsstruktur versehen wird, die eingerichtet ist das Blech beim Strukturieren in Breitenrichtung zu fixieren.

4. Verfahren nach einem der vorstehenden Ansprüche,
**dadurch gekennzeichnet, dass** das Blech (110) beim Strukturieren in Längenrichtung (L) verlaufende Wellenberge (222) und Wellentäler (224) erhält, die jeweils im Scheitelbereich mit rillenförmigen Einbuchtungen (226) versehen werden.

5. Verfahren nach Anspruch 4,
**dadurch gekennzeichnet, dass** die rillenförmigen Einbuchtungen (226) zusammen mit der angrenzenden Oberfläche der benachbarten unstrukturierten Platte (210, 214, 218, 410, 420) einen Hohlraum (228) bilden, in dem sich das Lot (220, 412, 418, 422, 428) beim Vakuumlöten sammelt.

6. Verfahren nach einem der Ansprüche 3 bis 5,
**dadurch gekennzeichnet, dass** das Lot (220, 412, 418, 422, 428) lokal in Form von parallelen Streifen (220) auf die unstrukturierte Platte (210, 214, 218, 410, 420) aufgedruckt wird, deren Abstand der Periodizität des Wellenprofils (221) entspricht.

7. Verfahren nach Anspruch 6 in Verbindung mit Anspruch 5,
**dadurch gekennzeichnet, dass** die rillenförmigen Einbuchtungen (226) mit den Lotstreifen (220) beim Zusammensetzen zur Deckung kommen.

8. Verfahren nach Anspruch 7,
**dadurch gekennzeichnet, dass** das Volumen des Lotes (220, 412, 418, 422, 428) beim Aufdrucken des Lotstreifens (220) so eingestellt wird, dass es im Wesentlichen dem Volumen des Hohlraums (228) entspricht.

9. Verfahren nach einem der vorstehenden Ansprüche,
**dadurch gekennzeichnet, dass** das Blech (110) im Wesentlichen durch Hohlprägen strukturiert wird.

10. Mikrostrukturbauteil (500) zum Leiten eines Fluids mit abwechselnd aufeinander gestapelten mikrostrukturierten Platten (116, 118, 212, 216, 416, 426) und unstrukturierten Platten (210, 214, 218, 410, 420),
wobei zwischen den Platten Fluidleitungen (230, 232) ausgebildet sind, die jeweils von einer Oberfläche der mikrostrukturierten Platte (116, 118, 212, 216, 416, 426) und einer angrenzenden Oberfläche der benachbarten unstrukturierten Platte (210, 214, 218, 410, 420) in Umfangsrichtung begrenzt sind, und **dadurch gekennzeichnet, dass**
die mikrostrukturierten Platten (116, 118, 212, 216, 416, 426) in Breitenrichtung (B) ein Wellenprofil (221) aufweisen, das jeweils im Scheitelbereich rillenförmige Einbuchtungen (226) aufweist,
wobei in den Scheitelbereichen Lotverbindungen (238) zwischen den mikrostrukturierten und unstrukturierten Platten bestehen und das Lot (220, 221, 412, 418, 422, 428) einen zwischen den rillenförmigen Einbuchtungen (226) und einer angrenzenden Oberfläche der benachbarten unstrukturierten Platte (210, 214, 218, 410, 420) gebildeten Hohlraum (228) ausfüllt und

11. Mikrostrukturbauteil (500) nach Anspruch 10,
**dadurch gekennzeichnet, dass** das Wellenprofil (221) periodisch ist.

12. Mikrostrukturbauteil (500) nach Anspruch 10 oder 11,
**gekennzeichnet durch** eine erste mikrostrukturierte Platte (426) mit dem Wellenprofil (221) und einer Ausdehnung L₁ in Längenrichtung (L) und eine zweite mikrostrukturierte Platte (416) mit dem Wellenprofil (221) und einer Ausdehnung L₂ in Längenrichtung (L), wobei die Ausdehnung L₁ der ersten mikrostrukturierte Platte (426) größer ist als die Ausdehnung L₂ der zweiten mikrostrukturierte Platte (416) und wobei das Mikrostrukturbauteil aufeinander folgend eine unstrukturierte Platte (410), eine zweite mikrostrukturierte Platte (416), eine unstrukturierte Platte (420), eine erste mikrostrukturierte Platte (426) aufweist,

13. Mikrostrukturbauteil (500) nach Anspruch 12,
**dadurch gekennzeichnet, dass** die erste mikrostrukturierte Platte (426) in der Plattenebene beidseitig in Längenrichtung (L) von Leisten (424) eingefasst ist.

14. Mikrostrukturbauteil (500) nach Anspruch 12 oder 13,
**dadurch gekennzeichnet, dass** die zweite mikrostrukturierte Platte (416) in der Plattenebene umlaufend von einem Rahmen (414) eingefasst ist, der auf den beiden Stirnseiten der mikrostrukturierten Platte (416) jeweils eine Verteilerstruktur zum Verteilen von Fluid in Breitenrichtung (B) auf die Fluidleitungen (230, 232) zwischen der zweiten mikrostrukturierten Platte (416) und den beiden angrenzenden unstrukturierten Platten (410, 420) bildet.

## Claims

1. Method for producing a microstructure component (500), in which
- a metal sheet (110) is guided through the gap between a pair of profile rollers (100) which defines a width direction (B), which sheet is thereby microstructured, wherein a corrugated profile (221) is produced in the width direction (B),
- a microstructured plate (116, 118, 212, 216, 416, 426) is cut from the microstructured metal sheet (110),
- a solder (220, 412, 418, 422, 428) is applied to an unstructured plate (210, 214, 218, 410, 420),
- the microstructured plate (116, 118, 212, 216, 416, 426) and the unstructured plate (210, 214, 218, 410, 420) are put together to form a stack (200, 400)
- and the stack (200, 400) is connected by means of vacuum soldering.

2. Method according to claim 1, **characterised in that** the corrugated profile (221) is periodically structured.

3. Method according to any of the preceding claims, **characterised in that**, when being structured, the metal sheet (110) is equipped with an auxiliary structure which is designed to fix the metal sheet in the width direction when being structured.

4. Method according to any of the preceding claims, **characterised in that**, when being structured, the metal sheet (110) is provided with corrugation peaks (222) and corrugation troughs (224) extending in the longitudinal direction (L), which are each equipped with groove-shaped indentations (226) in the apex region.

5. Method according to claim 4, **characterised in that** the groove-shaped indentations (226) form a cavity (228) together with the adjacent surface of the neighbouring unstructured plate (210, 214, 218, 410, 420), in which cavity the solder (220, 412, 418, 422, 428) collects during the vacuum soldering.

6. Method according to any of claims 3 to 5, **characterised in that** the solder (220, 412, 418, 422, 428) is locally pressed onto the unstructured plate (210, 214, 218, 410, 420) in the form of parallel strips (220), the spacing of which corresponds to the periodicity of the corrugated profile (221).

7. Method according to claim 6 in conjunction with claim 5, **characterised in that**, when being assembled, the groove-shaped indentations (226) coincide with the solder strips (220).

8. Method according to claim 7, **characterised in that** the volume of the solder (220, 412, 418, 422, 428) is adjusted when the solder strip (220) is pressed on such that said solder substantially corresponds to the volume of the cavity (228).

9. Method according to any of the preceding claims, **characterised in that** the metal sheet (110) is substantially structured by means of embossing.

10. Microstructure component (500) for conducting a fluid by means of microstructured plates (116, 118, 212, 216, 416, 426) and unstructured plates (210, 214, 218, 410, 420) which are alternately stacked on top of one another, fluid lines (230, 232) being formed between the plates, which fluids lines are each delimited by a surface of the microstructured plate (116, 118, 212, 216, 416, 426) and an adjacent surface of the neighbouring unstructured plate (210, 214, 218, 410, 420) in the circumferential direction, and **characterised in that** the microstructured plates (116, 118, 212, 216, 416, 426) have a corrugated profile (221) in the width direction (B), which profile has groove-shaped indentations (226) in each of the apex regions, solder connections (238) being present in the apex regions between the microstructured and unstructured plates and the solder (220, 221, 412, 418, 422, 428) filling a cavity (228) formed between the groove-shaped indentations (226) and an adjacent surface of the neighbouring unstructured plate (210, 214, 218, 410, 420).

11. Microstructure component (500) according to claim 10, **characterised in that** the corrugated profile (221) is periodic.

12. Microstructure component (500) according to either claim 10 or claim 11, **characterised by** a first microstructured plate (426) comprising the corrugated profile (221) and an extension L₁ in the longitudinal direction (L) and a second microstructured plate (416) comprising the corrugated profile (221) and an extension L₂ in the longitudinal direction (L), the extension L₁ of the first microstructured plate (426) being greater than the extension L₂ of the second microstructured plate (416) and the microstructure component having, in succession, an unstructured plate (410), a second microstructured plate (416), an unstructured plate (420) and a first microstructured plate (426).

13. Microstructure component (500) according to claim 12, **characterised in that**, in the plate plane, the first microstructured plate (426) is bordered by bars (424) on either side in the longitudinal direction (L).

14. Microstructure component (500) according to either claim 12 or claim 13, **characterised in that**, in the plate plane, the second microstructured plate (416) is peripherally bordered by a frame (414) which, at both ends of the microstructured plate (416), forms a distribution structure in each case for distributing fluid in the width direction (B) to the fluid lines (230, 232) between the second microstructured plate (416) and the two adjacent unstructured plates (410, 420).

## Revendications

1. Procédé de fabrication d'un composant à microstructure (500), dans lequel
- une tôle (110) est guidée à travers une fente définissant un sens de largeur (B) d'une paire de cylindres à profilés (100) et ce faisant est micro-structurée, un profil ondulé (221) étant produit dans le sens de la largeur (B),
- à partir de la tôle micro-structurée (110) une plaque micro-structurée (116, 118, 212, 216, 416, 426) est tronçonnée,
- une soudure (220, 412, 418, 422, 428) est appliquée sur une plaque non structurée (210, 214, 218, 410, 420),
- la plaque micro-structurée (116, 118, 212, 216, 416, 426) et la plaque non structurée (210, 214, 218, 410, 420) sont assemblées en une pile (200, 400)
- et la pile (200, 400) est reliée à l'aide de soudures sous vide.

2. Procédé selon la revendication 1, **caractérisé en ce que** le profil ondulé (221) est structuré périodiquement.

3. Procédé selon l'une des revendications précédentes, **caractérisé en ce que** la tôle (110) lors de la structuration est dotée d'une structure auxiliaire qui est mise en place pour fixer la tôle dans le sens de la largeur lors de la structuration.

4. Procédé selon l'une des revendications précédentes, **caractérisé en ce que** la tôle (110) lors de la structuration conserve les crêtes d'onde (222) et les creux d'onde (224) passant dans le sens de la longueur (L) qui sont dotés à chaque fois d'indentations (226) en forme de gorges dans la zone du sommet.

5. Procédé selon la revendication 4, **caractérisé en ce que** les indentations (226) en forme de gorges forment conjointement avec la surface adjacente de la plaque non structurée contiguë (210, 214, 218, 410, 420) une cavité (228) dans laquelle la soudure (220, 412, 418, 422, 428) s'amasse lors de la soudure sous vide.

6. Procédé selon l'une des revendications 3 à 5, **caractérisé en ce que** la soudure (220, 412, 418, 422, 428) est appliquée localement en forme de bandes parallèles (220) sur la plaque non structurée (210, 214, 218, 410, 420), dont l'écartement correspond à la périodicité du profil ondulé (221).

7. Procédé selon la revendication 6 en relation avec la revendication 5, **caractérisé en ce que** les indentations (226) en forme de gorges lors de l'assemblage se recouvrent avec les bandes de soudure (220).

8. Procédé selon la revendication 7, **caractérisé en ce que** le volume de la soudure (220, 412, 418, 422, 428) lors de l'application du métal d'apport en bande (220) est ajusté de manière telle qu'il correspond essentiellement au volume de la cavité (228).

9. Procédé selon l'une des revendications précédentes, **caractérisé en ce que** la tôle (110) est structurée essentiellement par estampage.

10. Composant à microstructure (500) pour le guidage d'un fluide avec des plaque micro-structurées (116, 118, 212, 216, 416, 426) et des plaques non structurée (210, 214, 218, 410, 420) empilées les unes sur les autres en alternance, dans lequel des conduites de fluide (230, 232) sont conçues entre les plaques, qui sont à chaque fois limitées dans le sens circonférentiel par une surface de la plaque micro-structurée (116, 118, 212, 216, 416, 426) et une surface adjacente de la plaque non structurée contiguë (210, 214, 218, 410, 420), et **caractérisé en ce que** les plaques micro-structurées (116, 118, 212, 216, 416, 426) présentent dans le sens de largeur (B) un profil ondulé (221), qui présente à chaque fois des indentations (226) en forme de gorges dans la zone du sommet, dans lequel des liaisons de soudure (238) existent dans les zones de sommet entre les plaques micro-structurées et non structurées et la soudure (220, 221, 412, 418, 422, 428) remplit une cavité (228) formée entre les indentations (226) en forme de gorges et une surface adjacente de la plaque non structurée contiguë (210, 214, 218, 410, 420).

11. Composant à microstructure (500) selon la revendication 10, **caractérisé en ce que** le profil ondulé (221) est périodique.

12. Composant à microstructure (500) selon la revendication 10 ou 11, **caractérisé par** une première plaque micro-structurée (426) avec le profil ondulé (221) et une extension L₁ dans le sens de la longueur (L) et une deuxième plaque micro-structurée (416) avec le profil ondulé (221) et une extension L₂ dans le sens de la longueur (L), dans lequel l'extension L₁ de la première plaque micro-structurée (426) est plus grande que l'extension L₂ de la deuxième plaque micro-structurée (416) et dans lequel le composant à microstructure présente, se succédant les unes aux autres, une plaque non structurée (410), une deuxième plaque micro-structurée (416), une plaque non structurée (420), une première plaque micro-structurée (426).

13. Composant à microstructure (500) selon la revendication 12, **caractérisé en ce que** la première plaque micro-structurée (426) est bordée de baguettes (424) dans le plan de la plaque des deux côtés dans le sens de la longueur (L).

14. Composant à microstructure (500) selon la revendication 12 ou 13, **caractérisé en ce que** la deuxième plaque micro-structurée (416) est bordée dans le plan de la plaque sur sa périphérie d'un cadre (414), qui forme sur les deux faces frontales de la plaque micro-structurée (416) à chaque fois une structure de répartition pour répartir le fluide dans le sens de la largeur (B) sur les conduites de fluide (230, 232) entre la deuxième plaque micro-structurée (416) et les deux plaques non structurées adjacentes (410, 420).
